# EUROPÄISCHE PATENTSCHRIFT

(11) **EP 3 010 095 B1**
(45) Veröffentlichungstag und Bekanntmachung des Hinweises auf die Patenterteilung: **26.12.2018**
(21) Anmeldenummer: 15187396.5
(22) Anmeldetag: 29.09.2015
(51) Int. Cl.: H01R 12/58, H05K 3/30, H01R 43/16, H01R 9/24

(54) **EINPRESSKONTAKT**
PRESS-FIT CONTACT
CONTACT D'INSERTION

(30) Priorität: 17.10.2014 DE 102014221089
(43) Veröffentlichungstag der Anmeldung: 20.04.2016
(73) Patentinhaber: ROBERT BOSCH GMBH, 70442 Stuttgart (DE)
(72) Erfinder: Gueckel, Richard, 71701 Schwieberdingen (DE); Kroeckel, Markus, 71701 Schwieberdingen (DE)

(56) Entgegenhaltungen:
- EP-A2- 0 219 935
- DE-A1-102004 060 084
- US-A- 4 631 824
- US-A- 6 083 060
- US-A1- 2008 200 049
- US-A1- 2011 256 780
- US-B1- 6 186 843

## Beschreibung

### Stand der Technik

Die Erfindung betrifft einen elektrischen Einpresskontakt gemäß Anspruch 1 und ein Verfahren zum Erzeugen eines Einpresskontaktes gemäß Anspruch 10. Der Einpresskontakt weist einen Kontaktkörper auf und eine Mehrzahl von Einpressstiften, wobei die Einpressstifte jeweils an den Kontaktkörper angeformt sind. Die Einpressstifte erstrecken sich jeweils von dem Kontaktkörper abweisend, in eine gemeinsame Richtung.

Elektrische Einpresskontakte mit einem Kontaktkörper und an den Kontaktkörper angeformten Einpressstiften können bisher im Metall-Spritzgussverfahren erzeugt werden. Die Gestaltung der Einpressstifte, insbesondere eine Form der Einpressstifte, ist dabei jedoch beschränkt oder aufwändig, insoweit zur Ausgestaltung eines Einpressstiftes Hinterschneidungen erforderlich sind.

Aus der DE 10 2004 060084 ist ein Anschlusselement für Leiterplatten bekannt, das aus Blechlagen gebildet ist und an den Einpresskontakte angebunden sind. Aus der US 2011/02567780 ist ein Kontaktträger für einen elektrischen Verbinder bekannt, der eine Anschlusslasche und eine Mehrzahl von an die Anschlusslasche angeformten Fingerkontakten umfasst.

Aus der US 2008 0200049 A1 ist ein Verbinder mit umspritzten Kontakten bekannt, die an ein Leadframe angeformt sind.

### Offenbarung der Erfindung

Erfindungsgemäß ist im elektrischen Einpresskontakt der Kontaktkörper wenigstens teilweise aus miteinander verbundenen Metallbandabschnitten eines Metallbandes gebildet. Die Einpressstifte sind an den Metallbandabschnitten entlang einer Längserstreckung des Metallbandabschnitts zueinander beabstandet angeformt. So kann der Einpresskontakt vorteilhaft mittels Stanzen, Stanzumformen oder Laserschneiden aus einem Metallband, insbesondere einem auf einer Rolle gewickelten Metallband, erzeugt werden. Der Einpresskontakt kann so vorteilhaft aufwandsgünstig, beispielsweise durch Abspulen des Metallbandes von der Rolle und Aufteilen des Metallbandes in Metallbandlängsabschnitte, erzeugt werden.

In einer bevorzugten Ausführungsform ist der Einpresskontakt aus einem gefalteten Metallband gebildet. Bevorzugt ist durch das gefaltete Metallband eine ununterbrochene Faltspur gebildet. Dadurch kann der Einpresskontakt vorteilhaft aufwandsgünstig erzeugt werden. Das Metallband kann so beispielsweise von der zuvor genannten Metallbandrolle abgespult werden, wobei das Metallband entlang seiner Längserstreckung abgewinkelt oder gefaltet werden kann, sodass sich zueinander parallel erstreckende Metallbandabschnitte gebildet sind. Vorteilhaft kann der Einpresskontakt so mittels der Falttechnik aufwandsgünstig erzeugt werden. Vorteilhaft können so Einpresskontakte mit zueinander verschiedenen Umfangsformen gebildet sein.

Die Metallbandabschnitte können in einer anderen Ausführungsform durch Abschneiden oder Abtrennen der Metallbandabschnitte von der Metallbandspule erzeugt werden. Die Metallbandabschnitte können dann beispielsweise in einem folgenden Schritt zum Erzeugen des Einpresskontakts zueinander parallel angeordnet werden, oder aufeinandergelegt werden und beispielsweise mittels Verschweißen oder Verlöten miteinander verbunden werden.

In einer bevorzugten Ausführungsform ist das Metallband des Einpresskontakts in zueinander entgegengesetzte Richtungen gefaltet, sodass der Einpresskontakt entlang einer insbesondere ununterbrochenen Faltspur aufeinanderfolgende Metallbandabschnitte und Wendeabschnitte aufweist, wobei zueinander benachbarte Metallbandabschnitte jeweils mittels eines Wendeabschnitts miteinander verbunden sind. Die Faltspur bildet so einen insbesondere mäanderförmigen Kurvenzug.

In einer bevorzugten Ausführungsform ist der Wendeabschnitt U-förmig gebildet. So kann das Metallband zum Ausbilden des Einpresskontakts vorteilhaft platzsparend gefaltet werden.

In einer bevorzugten Ausführungsform erstrecken sich die Metallbandabschnitte parallel zueinander. Dadurch können die Einpressstifte vorteilhaft in dem vorbestimmten Muster zueinander angeordnet sein.

Der Erfindung nach berühren zueinander benachbarte Metallbandabschnitte einander. Der Einpresskontakt kann so vorteilhaft eine gute elektrische Leitfähigkeit oder zusätzlich eine kleine elektrische Kapazität aufweisen.

Bevorzugt berühren die zueinander benachbarten Metallbandabschnitte mit ihrer flachen Erstreckung einander, sodass einender gegenüberliegende Oberflächenbereiche zueinander benachbarter Metallbandabschnitte einander berühren. So kann vorteilhaft ein zusätzlicher galvanischer Kontakt zwischen den Metallbandabschnitten ausgebildet sein, sodass der Einpresskontakt eine gute elektrische Leitfähigkeit aufweist.

In einer bevorzugten Ausführungsform ist wenigstens ein Teil der Metallbandabschnitte miteinander stoffschlüssig verbunden, insbesondere verschweißt oder verlötet. So können die Metallbandabschnitte, insbesondere der Variante des gefalteten Metallbandes, nicht auseinanderbiegen und werden so fest in der gefalteten Form gehalten. Vorteilhaft können die Metallbandabschnitte im Falle der separat gebildeten Metallbandabschnitte mittels wenigstens einer Schweißstelle, oder wenigstens einer Lotstelle, miteinander verbunden, und so zusammengehalten sein.

In einer bevorzugten Ausführungsform weist wenigstens ein Teil der Einpressstifte einen Durchbruch auf, wobei der Einpressstift im Bereich des Durchbruchs federnd ausgebildet ist. So kann der Einpresskontakt vorteilhaft leicht und mit wenig Kraftaufwand in einen Schaltungsträger, insbesondere in den Einpressstiften jeweils entsprechende Aussparungen des Schaltungsträgers, eingepresst werden.

Der Erfindung nach sind Einpressstifte zueinander benachbarter Metallbandabschnitte zueinander versetzt angeordnet. So kann der Einpresskontakt mit einem Schaltungsträger vorteilhaft einen sicheren Halt erzeugen.

In einer bevorzugten Ausführungsform weist der Einpresskontakt einen elektrischen Anschluss, insbesondere einen Schraubanschluss oder einen Steckanschluss, auf. Der elektrische Anschluss erstreckt sich bevorzugt entgegengesetzt zu den Einpressstiften, abweisend von dem Kontaktkörper. Die Erfindung betrifft auch ein Verfahren gemäß Anspruch 10 zum Erzeugen eines Einpresskontaktes. Bei dem Verfahren werden entlang einer Längserstreckung aufeinanderfolgende Metallbandabschnitte eines Metallbandes aufeinander gefaltet, wobei an das Metallband quer von einer Längserstreckung des Metallbandes abweisende Einpressstifte angeformt sind. So kann der Einpresskontakt vorteilhaft aufwandsgünstig mittels Falten eines Metallbandes und weiter bevorzugt Abschneiden des gefalteten Metallbandes, insbesondere von einer Metallbandrolle, erzeugt werden.

Die Erfindung betrifft auch ein Kontaktsystem. Das Kontaktsystem umfasst wenigstens einen Einpresskontakt der vorbeschriebenen Art und einen Schaltungsträger. Der Schaltungsträger weist wenigstens eine elektrisch leitfähige Schicht und wenigstens eine elektrisch isolierende Schicht auf, wobei die Schichten bevorzugt miteinander verbunden sind. Der Schaltungsträger weist für jeden Einpressstift des Einpresskontaktes eine insbesondere rinnenförmige Aussparung, oder einen Durchbruch auf. Der Einpressstift ist ausgebildet, beim Einpressen in die Aussparung oder den Durchbruch kraftschlüssig oder zusätzlich stoffschlüssig, beispielsweise mittels Kaltverschweißung, in dem Schaltungsträger, insbesondere in der elektrisch leitfähigen Schicht, festzuhalten.

Die Erfindung wird nun im Folgenden anhand von Figuren und weiteren Ausführungsbeispielen beschrieben. Weitere vorteilhafte Ausführungsvarianten ergeben sich aus den in den Figuren und in den abhängigen Ansprüchen beschriebenen Merkmalen.
Figur 1 zeigt ein Ausführungsbeispiel für einen Einpresskontakt, welcher aus aufeinandergelegten Metallbandabschnitten zusammengefügt ist, wobei an die Metallbandabschnitte jeweils Einpressstifte angeformt sind;
Figur 2 zeigt ein Ausführungsbeispiel für einen aus Metallbandabschnitten erzeugten Einpresskontakt, bei dem anders als in Figur 1 ein Metallbandabschnitt Einoressstiftlos ausgebildet ist und einen elektrischen Schraubanschluss aufweist;
Figur 3 zeigt ein Ausführungsbeispiel für einen Einpresskontakt, welcher aus einem entlang einer Faltspur gefalteten Metallbandabschnitt erzeugt ist, wobei an den Metallbandabschnitt Einpresskontakte angeformt sind.

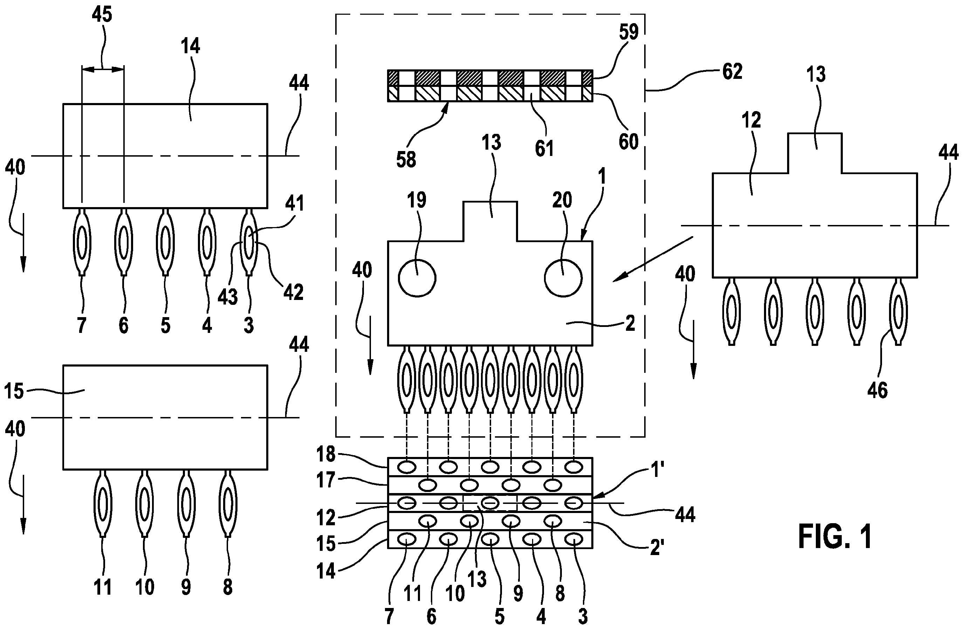

Figur 1 zeigt ein Ausführungsbeispiel für einen Einpresskontakt 1. Der Einpresskontakt 1 weist einen Kontaktkörper 2 auf, wobei an den Kontaktkörper 2 eine Mehrzahl, insbesondere wenigstens zwei, oder eine Vielzahl, insbesondere wenigstens zehn, Einpressstifte angeformt sind. Der Einpresskontakt 1 weist in diesem Ausführungsbeispiel 23 Einpressstifte auf.

Dargestellt ist auch ein Metallbandabschnitt 14 als Teil zum Erzeugen des Einpresskontakts 1. An den Metallbandabschnitt 14 sind in diesem Ausführungsbeispiel fünf Einpressstifte, nämlich ein Einpressstift 3, ein Einpressstift 4, ein Einpressstift 5, ein Einpressstift 6 und ein Einpressstift 7, angeformt, welche sich jeweils in eine gemeinsame Richtung 40 erstrecken. Die Einpressstifte 3, 4, 5, 6 und 7 weisen jeweils einen Durchbruch auf, sodass die Einpressstifte 3, 4, 5, 6 und 7 jeweils im Bereich des Durchbruchs federnd ausgebildet sind. Der Durchbruch 41 des Einpressstifts 3 ist beispielhaft bezeichnet. Der Einpressstift 3 ist im Bereich des Durchbruchs 41 auf einem Längsabschnitt O-förmig ausgebildet, sodass im Bereich des Durchbruchs zwei Federabschnitte 42 und 43 voneinander beabstandet gebildet sind. Die Federabschnitte 42 und 43 sind jeweils ausgebildet, in den Durchbruch 41 hineinzufedern.

Der Metallbandabschnitt 14 ist in diesem Ausführungsbeispiel zusammen mit den Einpressstiften 3, 4, 5, 6 und 7 einstückig ausgebildet und ist beispielsweise aus einem gestanzten oder lasergeschnittenen Metallblech, insbesondere einem Kupferblech, gebildet.

Dargestellt ist auch ein Metallbandabschnitt 15, welcher vier Einpressstifte, nämlich einen Einpressstift 8, einen Einpressstift 9, einen Einpressstift 10 und einen Einpressstift 11 aufweist. Die Einpressstifte 8, 9, 10 und 11 sind jeweils an den Metallbandabschnitt 15 angeformt und erstrecken sich jeweils in einer gemeinsame Richtung 40. Die Metallbandabschnitte 14 und 15 sind in diesem Ausführungsbeispiel rechteckig ausgebildet und sind beispielsweise durch Abtrennen von einem sich längs erstreckenden Metallband gebildet, wobei an das Metallband die Einpressstifte wie die Einpressstifte 3, 4, 5, 6, 7, 8, 9, 10 und 11 angeformt sind. Die Einpressstifte 3, 4, 5, 6, 7, 8, 9, 10 und 11 sind jeweils entlang einer Längserstreckung 44 der Metallbandabschnitte 14 beziehungsweise 15 zueinander beabstandet, insbesondere in einem vorbestimmten Abstand 45 zueinander angeordnet.

Die Metallbandabschnitte 14 und 15 können zum Erzeugen des Einpresskontakts 1 mit ihrer flachen Erstreckung derart aufeinandergelegt werden, dass die Einpressstifte 3, 4, 5, 6, 7, 8, 9, 10 und 11 sich jeweils in eine gemeinsame Richtung erstrecken. Zu den Metallbandabschnitten 14 und 15 kann ein weiterer Metallbandabschnitt 12 angefügt werden. Der Metallbandabschnitt 12 weist wie die Metallbandabschnitte 14 und 15 Einpressstifte auf, von denen ein Einpressstift 46 beispielhaft bezeichnet ist. Der Metallbandabschnitt 12 weist zusätzlich zu den Einpressstiften wie den Einpressstift 46 einen elektrischen Anschluss 13 auf, welcher sich in der flachen Erstreckung des Metallbandabschnitts 12 entgegengesetzt zu den Einpressstiften 46, also in zu der gemeinsamen Richtung 40 entgegengesetzten Richtung, erstreckt.

Der Anschluss 13 ist in diesem Ausführungsbeispiel als Blechlasche ausgebildet. An den Anschluss 13 kann beispielsweise mittels Widerstandsschweißen, mittels Durchsetzfügen oder mittels Löten oder mittels Aufstecken eines Steckers eine Verbindungsleitung oder ein Verbindungskabel angeschlossen werden.

Der Anschluss 13, insbesondere die zuvor erwähnte Blechlasche, kann auch zum Erzeugen eines Schraubanschlusses oder eines Steckanschlusses rundgeprägt werden.

Der Einpresskontakt 1 weist in diesem Ausführungsbeispiel neben den bereits beschriebenen Metallbandabschnitten 14 und 15 den Metallbandabschnitt 12 auf, welcher gemeinsam mit den Metallbandabschnitten 14 und 15 zusammengefügt ist. Zusätzlich zu dem Metallbandabschnitt 15 weist der Einpresskontakt 1 auch zwei weitere Metallbandabschnitte 17 und 18 auf, wobei der Metallbandabschnitt 17 wie der Metallbandabschnitt 15 mit vier Einpressstiften ausgebildet ist und der Metallbandabschnitt 18 wie der Metallbandabschnitt 14 mit fünf Einpressstiften ausgebildet ist.

Die Metallbandabschnitte wie die Metallbandabschnitte 14 und 15 mit fünf beziehungsweise vier Einpressstiften sind aufeinander zueinander abwechselnd angeordnet. So sind die Kontaktstifte von einander zusammengefügten, aufeinanderfolgenden Metallbandabschnitten wie die Metallbandabschnitte 14 und 15, entlang der Längserstreckung 44 der Metallbandabschnitte zueinander versetzt angeordnet.

Der in einer Aufsicht auf die Kontaktstifte in Figur 1 dargestellte Einpresskontakt 1' mit dem Kontaktkörper 2' weist in diesem Ausführungsbeispiel die Metallbandabschnitte 14, 15, 12, 17 und 18 auf. An den Metallbandabschnitt 12 ist von den Einpressstiften abweisend der Anschluss 13 angeformt, welcher in der Aufsicht des Einpresskontaktes 1' gestrichelt gezeichnet ist.

Die Metallbandabschnitte 14, 15, 12, 17 und 18 sind mit ihrer flachen Erstreckung einander zusammengefügt, sodass die Metallbandabschnitte mit ihrer Längserstreckung 44 zueinander parallel angeordnet sind.

Die Metallbandabschnitte 14, 15, 12, 17 und 18 sind in diesem Ausführungsbeispiel mittels insbesondere zwei Schweißstellen 19 und 20 miteinander verschweißt und so zusammengehalten. Die Schweißstellen 19 und 20, insbesondere Schweißpunkte, sind beispielsweise mittels Widerstandsschweißen erzeugt.

Figur 1 zeigt auch einen Schaltungsträger 58, insbesondere DBC-Schaltungsträger. Der Schaltungsträger 58 weist eine elektrisch leitfähige Schicht 59 und eine elektrisch isolierende Schicht 59 auf. In dem Schaltungsträger 58 sind für die Einpressstifte des Einpresskontakts 1 Durchbrüche ausgebildet, von denen ein Durchbruch 61 beispielhaft bezeichnet ist. Der Schaltungsträger kann beispielsweise zusammen mit dem Einpresskontakt 1 ein Kontaktsystem 62 bilden.

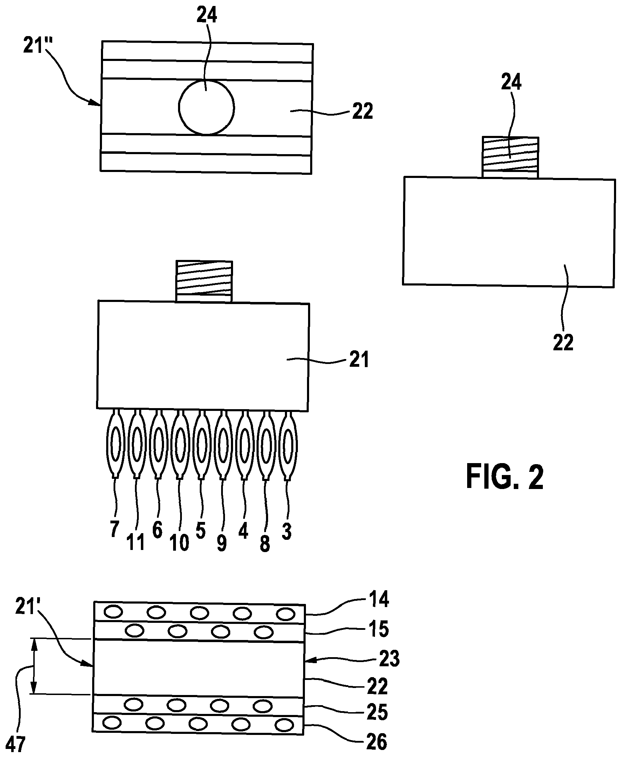

Figur 2 zeigt ein Ausführungsbeispiel für einen Einpresskontakt 21, welcher eine Variante des in Figur 1 bereits dargestellten Einpresskontakts 1 bildet.

Der Einpresskontakt 21 weist einen Metallbandabschnitt 22 auf, welcher einpressstiftlos ausgebildet ist, und so in diesem Ausführungsbeispiel eine Einpressstifte aufweist. Der Metallbandabschnitt 22 weist in diesem Ausführungsbeispiel einen elektrischen Anschluss 24 auf, welcher als Schraubzapfen mit einem Außengewinde ausgebildet ist. Der Metallbandabschnitt 24 weist in diesem Ausführungsbeispiel eine größere Dickenerstreckung 47 auf, als die übrigen Metallbandabschnitte des Einpresskontakts 21. Der Einpresskontakt 21 weist in diesem Ausführungsbeispiel zwei Metallbandabschnitte 14 und 15 auf, welche jeweils den Metallbandabschnitten 14 beziehungsweise 15 in Figur 1 entsprechen und jeweils die gleiche Anzahl und Art von Einpressstiften aufweisen. Der Einpresskontakt 21 weist auch zwei weitere Metallbandabschnitte 25 und 26 auf, wobei der Metallbandabschnitt 25 wie der Metallbandabschnitt 15 mit vier Einpressstiften ausgebildet ist und der Metallbandabschnitt 26 wie der Metallbandabschnitt 14 mit fünf Einpressstiften ausgebildet ist. Der Metallbandabschnitt 22, welcher einpressstiftlos ausgebildet ist, ist in diesem Ausführungsbeispiel von den Metallbandabschnitten 15 und 25 - nach Art eines Sandwiches - eingeschlossen. Die Metallbandabschnitte 14 und 26 schließen die Metallbandabschnitte 15, 22 und 25 - insbesondere nach Art eines Sandwiches - zwischeneinander ein. Die Metallbandabschnitte 14, 15, 25 und 26 und der Metallbandabschnitt 22 formen so gemeinsam einen Kontaktkörper 23, an den die Einpressstifte angeformt sind. Figur 2 zeigt den Einpresskontakt 21 in einer zeitlichen Aufsicht und in einer Aufsicht 21' auf die Einpresskontakte und in einer Aufsicht 21" in einer Aufsicht auf den elektrischen Anschluss 24.

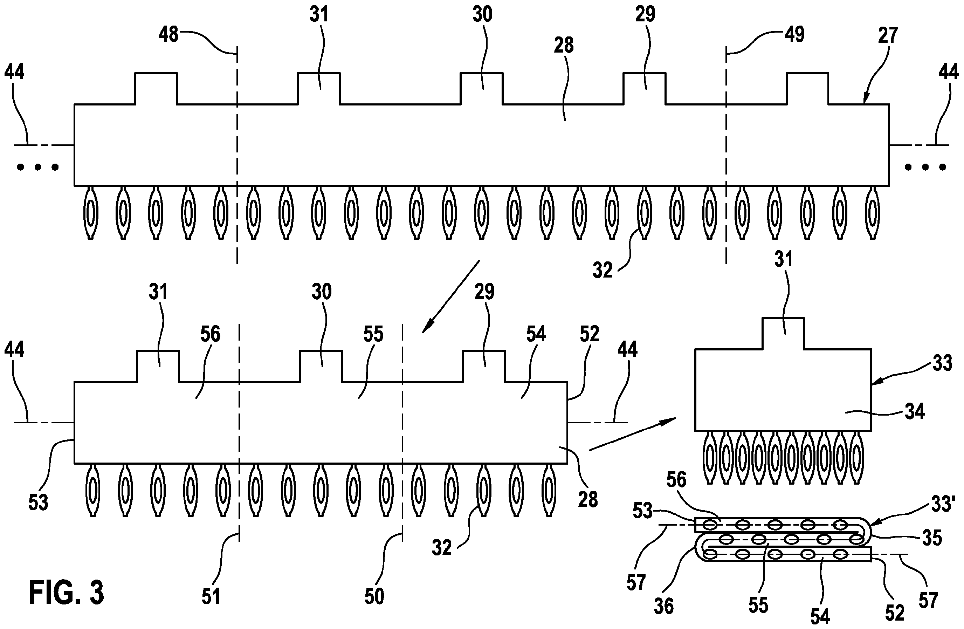

Figur 3 zeigt ein Ausführungsbeispiel für einen Einpresskontakt 33 und ein Metallband 27, aus dem der Einpresskontakt 33 geformt werden kann. Das Metallband 27 weist eine Vielzahl von Einpressstiften auf, von denen ein Einpressstift 32 beispielhaft bezeichnet ist. Die Einpressstifte sind entlang einer Längserstreckung 44 des Metallbandes 27 voneinander gleichmäßig beabstandet.

Ein Metallbandabschnitt 28 kann - beispielsweise mittels Sägen, mittels Laserschneiden oder mittels eines Trennmessers - entlang einer Trennlinie 48 und einer Trennlinie 49 von dem Metallband 27 abgetrennt werden. Das Metallband 27 weist in seiner flachen Erstreckung auf einer zu den Einpressstiften, wie den Einpressstift 32, gegenüberliegenden Seite zueinander gleichmäßig beabstandete und von dem Metallband 27 abweisende Anschlüsse auf, welche jeweils durch eine Blechlasche gebildet sind.

Der Metallbandabschnitt 28 weist in diesem Ausführungsbeispiel drei Anschlüsse 29, 30 und 31 auf, welche jeweils voneinander beabstandet entlang der Längserstreckung 44 angeordnet sind.

Der Metallbandabschnitt 28 weist in diesem Ausführungsbeispiel 15 Einpressstifte auf, welche jeweils an den Metallbandabschnitt 28 angeformt sind.

Das Metallband wie das Metallband 27 kann beispielsweise mittels Stanzen oder Laserschneiden aus einem Metallblech, insbesondere einem Kupferblech, geformt sein.

Der Metallbandabschnitt 28 kann zum Erzeugen des Einpresskontaktes 33 entlang einer Knicklinie 50 und entlang einer Knicklinie 51 gefaltet werden. Die Knicklinien 50 und 51 sind in diesem Ausführungsbeispiel jeweils entlang der Längserstreckung 44 voneinander beabstandet und verlaufen jeweils orthogonal zur Längserstreckung 44. Die Knicklinien 50 und 51 schließen in diesem Ausführungsbeispiel fünf Einpressstifte und den Anschluss 30 zwischeneinander ein.

Zwischen der Knicklinie 50 und einem Ende 52 erstreckt sich entlang der Längsachse 44, zuvor auch Längserstreckung genannt, ein Metallbandabschnitt 54, welcher einen Teil des Metallbandabschnittes 28 bildet. Zwischen den Knicklinien 50 und 51 erstreckt sich entlang der Längsachse 44 ein Metallbandabschnitt 55, und zwischen der Knicklinie 51 und einem von dem Ende 52 gegenüberliegenden Ende 53 des Metallbandabschnitts 28 erstreckt sich ein Metallbandabschnitt 56. Die Metallbandabschnitte 54 und 55 können nun durch Aufeinanderzufalten entlang der Knicklinie 50 zusammengefaltet werden, sodass die Metallbandabschnitte 54 und 55 aufeinanderliegen und einander gegenüberliegende Oberflächenbereiche der Metallbandabschnitte 54 und 55 einander berühren.

Der Metallbandabschnitt 56 kann darauffolgend mit dem Metallbandabschnitt 55 entlang der Knicklinie 51 zusammengefaltet werden, sodass einander gegenüberliegende Oberflächenbereiche der Metallbandabschnitte 55 und 56 einander berühren. Die Enden 52 und 53 des gefalteten Metallbandabschnitts 28 weisen voneinander ab.

Figur 3 zeigt den Einpresskontakt 33 in einer Aufsicht 33', in welcher der entlang der Längserstreckung 44 zwei Mal gefaltete Metallbandabschnitt 28 zu dem Einpresskontakt 33 geformt ist. Die Blechlaschen, welche jeweils die Anschlüsse 29, 30 und 31 bilden, liegen dabei aufeinander.

In einer anderen Ausführungsform können vor einem Zusammenfalten des Metallbandabschnitts 28 die Blechlaschen 29 und 31 entfernt werden. Der Einpresskontakt 33 weist in dieser Ausführungsform nur den Anschluss 30 auf.

Der Metallbandabschnitt 54 ist durch das Falten an der Knicklinie 50 entlang einer Faltspur 57 über einen Wendeabschnitt 36 mit dem Metallbandabschnitt 55 verbunden. Der Metallbandabschnitt 55 ist über einen Wendeabschnitt 35 mit dem Metallbandabschnitt 56 verbunden. Die Wendeabschnitte 35 und 36 sind in diesem Ausführungsbeispiel U-förmig ausgebildet. Die Metallbandabschnitte 54, 55 und 56 liegen in diesem Ausführungsbeispiel aufeinander und erstrecken sich jeweils mit ihrer flachen Erstreckung parallel zueinander.

Die Metallbandabschnitte 54, 55, und 56 sind so durch Falten des Metallbandabschnitts 28 entlang der Faltspur 57 erzeugt. Die Faltspur bildet so einen mäanderförmigen Kurvenzug.

Der Einpresskontakt wie der Einpresskontakt 33 kann zusätzlich zu den in Figur 3 dargestellten Metallbandabschnitten 54, 55 und 56 noch weitere Metallbandabschnitte aufweisen, welche durch die zuvor beschriebene Falttechnik miteinander verbunden sind. Dazu kann von dem Metallband 27 ein Metallbandabschnitt abgeschnitten werden, welcher länger ausgebildet ist als der Metallbandabschnitt 28 und welcher mehr Einpressstifte wie den Einpressstift 32 aufweist, als der Metallbandabschnitt 28.

## Patentansprüche

1. Elektrischer Einpresskontakt (1, 21, 33) mit einem Kontaktkörper (2, 22, 34) und einer Mehrzahl von Einpressstiften (3, 4, 8, 9, 32), wobei die Einpressstifte (3, 4, 8, 9, 32) jeweils an den Kontaktkörper (2, 22, 34) angeformt sind, und sich jeweils von dem Kontaktkörper (2, 22, 34) abweisend in eine gemeinsame Richtung (40) erstrecken, wobei der Kontaktkörper (2, 22, 34) wenigstens teilweise aus miteinander verbundenen Metallbandabschnitten (12, 14, 15, 17, 18, 54, 55, 56) eines Metallbandes (27) gebildet ist, wobei die Einpressstifte (3, 4, 8, 9, 32) an den Metallabschnitten entlang einer Längserstreckung des Metallbandes zueinander beabstandet angeformt sind, wobei die Metallbandabschnitte aufeinandergelegt sind, und so einander gegenüberliegende Oberflächenbereiche zueinander benachbarte Metallbandabschnitte (12, 14, 15, 17, 18, 54, 55, 56) einander berühren und wobei sich die Metallbandabschnitte (12, 14, 15, 17, 18, 54, 55, 56) zueinander parallel erstrecken, **dadurch gekennzeichnet, dass** an die Metallabschnitte (12, 14, 15, 17, 18, 54, 55, 56) jeweils Einpressstifte angeformt sind, wobei die Metallbandabschnitte (12, 14, 15, 17, 18, 54, 55, 56) derart miteinander verbunden sind, dass Einpressstifte (3, 4, 8, 9, 32) zueinander benachbarter Metallbandabschnitte (12, 14, 15, 17, 18, 54, 55, 56) entlang der Längserstreckung (44) der Metallbandabschnitte (12, 14, 15, 17, 18, 54, 55, 56) zueinander versetzt angeordnet sind.

2. Elektrischer Einpresskontakt (1, 21, 33) nach Anspruch 1,
**dadurch gekennzeichnet, dass**
wobei der Einpresskontakt (1, 21, 33) aus einem gefalteten Metallband (27) gebildet ist, wobei durch das gefaltete Metallband (27) eine ununterbrochene Faltspur (57) gebildet ist, welche einen mäanderförmigen Kurvenzug bildet, und das Metallband (27) des Einpresskontakts (1, 21, 33) in zueinander entgegengesetzten Richtungen gefaltet ist, so dass der Einpresskontakt (1, 21, 33) entlang einer Faltspur (57) aufeinanderfolgende Metallbandabschnitte (54, 55, 56) und Wendeabschnitte (35, 36) aufweist, wobei zueinander benachbarte Metallbandabschnitte (54, 55, 56) jeweils mittels eines Wendeabschnitts (35, 36) miteinander verbunden sind wobei an die Metallbandabschnitte (54, 55, 56) jeweils quer zur Längserstreckung (44) des Metallbandes (27) abweisende Einpressstifte (3, 4, 8, 9, 32) angeformt sind.

3. Elektrischer Einpresskontakt (1, 21, 33) nach Anspruch 2,
**dadurch gekennzeichnet, dass**
die Wendeabschnitte (35, 36) U-förmig gebildet sind.

4. Elektrischer Einpresskontakt (1, 21, 33) nach einem der vorhergehenden Ansprüche,
**dadurch gekennzeichnet, dass**
wenigstens ein Teil der Metallbandabschnitte (12, 14, 15, 17, 18, 54, 55, 56) miteinander stoffschlüssig verbunden, insbesondere verschweißt oder verlötet sind.

5. Elektrischer Einpresskontakt (1, 21, 33) nach einem der vorhergehenden Ansprüche,
**dadurch gekennzeichnet, dass**
wenigstens ein Teil der Einpressstifte (3, 4, 8, 9, 32) eine Ausnehmung oder einen Durchbruch (41) aufweist, wobei der Einpressstift (3, 4, 8, 9, 32) im Bereich des Durchbruchs (41) federnd ausgebildet ist.

6. Elektrischer Einpresskontakt (1, 21, 33) nach einem der vorhergehenden Ansprüche,
**dadurch gekennzeichnet, dass**
der Einpresskontakt (1, 21, 33) einen elektrischen Anschluss (13, 30), insbesondere Schraubanschluss oder Steckanschluss aufweist.

7. Elektrischer Einpresskontakt (1, 21, 33) nach einem der vorhergehenden Ansprüche 2 bis 7,
**dadurch gekennzeichnet, dass**
das Metallband (27) in seiner flachen Erstreckung auf einer zu den Einpressstiften (3, 4, 8, 9, 32) gegenüberliegenden Seite zueinander gleichmäßig beabstandete und von dem Metallband (27) abweisende Anschlüsse auf, welche jeweils durch eine Blechlasche (13, 29, 30, 31) gebildet sind, wobei die Blechlaschen aufeinandergefaltet sind.

8. Elektrischer Einpresskontakt (1, 21, 33) nach einem der vorhergehenden Ansprüche 6 oder 7,
**dadurch gekennzeichnet, dass**
der Anschluss (13, 29, 30, 31) durch einen Schraubabschluss oder Steckanschluss gebildet ist, wobei die Blechlasche (13, 29, 30, 32) zum Erzeugen eines Schraubanschlusses oder Steckabschlusses rundgeprägt ist.

9. Kontaktsystem mit wenigstens einem Einpresskontakt (1, 21, 33) nach einem der vorhergehenden Ansprüche und einem Schaltungsträger, wobei der Schaltungsträger (58) wenigstens eine elektrisch leitfähige Schicht (59) und wenigstens eine elektrisch isolierende Schicht (60) aufweist und für jeden Einpressstift (3, 4, 8, 9, 32) des Einpresskontaktes (1, 21, 33) eine Aussparung oder einen Durchbruch (61) aufweist, wobei der Einpressstift (3, 4, 8, 9, 32) ausgebildet ist, beim Einpressen in die Aussparung oder den Durchbruch (61) kraftschlüssig oder zusätzlich stoffschlüssig in dem Schaltungsträger (58) festzuhalten.

10. Verfahren zum Erzeugen eines Eipresskontaktes (1, 21, 33), bei dem entlang einer Längserstreckung (44) aufeinanderfolgende Metallbandabschnitte (54, 55, 56) eines Metallbandes (27) aufeinander gefaltet werden, **dadurch gekennzeichnet, dass** an die Metallbandabschnitte (54, 55, 56) jeweils quer zur Längserstreckung (44) des Metallbandes (27) abweisende Einpressstifte (3, 4, 8, 9, 32) angeformt sind, wobei die Einpressstifte (3, 4, 8, 9, 32) zueinander benachbarter Metallbandabschnitte (12, 14, 15, 17, 18, 54, 55, 56) entlang der Längserstreckung (44) der Metallbandabschnitte (12, 14, 15, 17, 18, 54, 55, 56) zueinander versetzt angeordnet sind.

## Claims

1. Electrical press-fit contact (1, 21, 33) having a contact body (2, 22, 34) and a plurality of press-fit pins (3, 4, 8, 9, 32), wherein the press-fit pins (3, 4, 8, 9, 32) are each integrally formed on the contact body (2, 22, 34) and each extend in a common direction (40) pointing away from the contact body (2, 22, 34), wherein the contact body (2, 22, 34) is at least partially formed from metal strip sections (12, 14, 15, 17, 18, 54, 55, 56) of a metal strip (27) which are connected to one another, wherein the press-fit pins (3, 4, 8, 9, 32) are integrally formed on the metal sections at a distance from one another along a longitudinal extent of the metal strip, wherein the metal strip sections are placed one on the other and thereby surface regions, which are opposite one another, of metal strip sections (12, 14, 15, 17, 18, 54, 55, 56), which are adjacent to one another, touch one another, and wherein the metal strip sections (12, 14, 15, 17, 18, 54, 55, 56) extend parallel to one another, **characterized in that** press-fit pins are integrally formed on each of the metal sections (12, 14, 15, 17, 18, 54, 55, 56), wherein the metal strip sections (12, 14, 15, 17, 18, 54, 55, 56) are connected to one another in such a way that press-fit pins (3, 4, 8, 9, 32) of metal strip sections (12, 14, 15, 17, 18, 54, 55, 56) which are adjacent to one another are arranged offset in relation to one another along the longitudinal extent (44) of the metal strip sections (12, 14, 15, 17, 18, 54, 55, 56).

2. Electrical press-fit contact (1, 21, 33) according to Claim 1, **characterized in that** wherein the press-fit contact (1, 21, 33) is formed from a folded metal strip (27), wherein an uninterrupted crease (57) is formed by the folded metal strip (27), which crease forms a meandering curve, and the metal strip (27) of the press-fit contact (1, 21, 33) is folded in opposite directions, so that the press-fit contact (1, 21, 33) has metal strip sections (54, 55, 56) and turning sections (35, 36) which follow one another along a crease (57), wherein metal strip sections (54, 55, 56) which are adjacent to one another are each connected to one another by means of a turning section (35, 36), wherein press-fit pins (3, 4, 8, 9, 32) which each point away transversely to the longitudinal extent (44) of the metal strip (27) are integrally formed on the metal strip sections (54, 55, 56) .

3. Electrical press-fit contact (1, 21, 33) according to Claim 2, **characterized in that** the turning sections (35, 36) are formed in a U-shaped manner.

4. Electrical press-fit contact (1, 21, 33) according to one of the preceding claims, **characterized in that** at least some of the metal strip sections (12, 14, 15, 17, 18, 54, 55, 56) are cohesively connected, in particular welded or soldered, to one another.

5. Electrical press-fit contact (1, 21, 33) according to one of the preceding claims, **characterized in that** at least some of the press-fit pins (3, 4, 8, 9, 32) have a recess or an aperture (41), wherein the press-fit pin (3, 4, 8, 9, 32) is of resilient design in the region of the aperture (41).

6. Electrical press-fit contact (1, 21, 33) according to one of the preceding claims, **characterized in that** the press-fit contact (1, 21, 33) has an electrical connection (13, 30), in particular screw connection or plug connection.

7. Electrical press-fit contact (1, 21, 33) according to one of the preceding Claims 2 to 7, **characterized in that** the metal strip (27), in its flat extent on a side which is situated opposite the press-fit pins (3, 4, 8, 9, 32), has connections which are at a uniform distance from one another and point away from the metal strip (27) and are each formed by a sheet-metal tab (13, 29, 30, 31), wherein the sheet-metal tabs are folded onto one another.

8. Electrical press-fit contact (1, 21, 33) according to one of the preceding Claims 6 and 7, **characterized in that** the connection (13, 29, 30, 31) is formed by a screw termination or plug connection, wherein the sheet-metal tab (13, 29, 30, 32) is stamped in a round shape in order to produce a screw connection or plug termination.

9. Contact system having at least one press-fit contact (1, 21, 33) according to one of the preceding claims and a circuit carrier, wherein the circuit carrier (58) has at least one electrically conductive layer (59) and at least one electrically insulating layer (60) and has a cutout or an aperture (61) for each press-fit pin (3, 4, 8, 9, 32) of the press-fit contact (1, 21, 33), wherein the press-fit pin (3, 4, 8, 9, 32), when pressed into the cutout or the aperture (61), is designed to hold firm in the circuit carrier (58) in a force-fitting or additionally cohesive manner.

10. Method for producing a press-fit contact (1, 21, 33), in which method metal strip sections (54, 55, 56) of a metal strip (27) which follow one another along a longitudinal extent (44) are folded onto one another, **characterized in that** press-fit pins (3, 4, 8, 9, 32) which each point away transversely to the longitudinal extent (44) of the metal strip (27) are integrally formed on the metal strip sections (54, 55, 56), wherein the press-fit pins (3, 4, 8, 9, 32) of metal strip sections (12, 14, 15, 17, 18, 54, 55, 56) which are adjacent to one another are arranged offset in relation to one another along the longitudinal extent (44) of the metal strip sections (12, 14, 15, 17, 18, 54, 55, 56).

## Revendications

1. Contact d'insertion électrique (1, 21, 33) comportant un corps de contact (2, 22, 34) et plusieurs broches d'insertion (3, 4, 8, 9, 32), dans lequel les broches d'insertion (3, 4, 8, 9, 32) sont respectivement formées sur le corps de contact (2, 22, 34) et s'étendent dans une direction commune (40) s'écartant respectivement du corps de contact (2, 22, 34),
dans lequel le corps de contact (2, 22, 34) est formé au moins partiellement à partir de sections de bande métallique reliées entre elles (12, 14, 15, 17, 18, 54, 55, 56) d'une bande métallique (27),
dans lequel les broches d'insertion (3, 4, 8, 9, 32) sont formées sur les sections métalliques de manière espacée les unes des autres le long d'une étendue longitudinale de la bande métallique, dans lequel les parties de bande métallique sont superposées les unes aux autres de manière à ce que des zones de surface opposées de sections de bande métallique (12, 14, 15, 17, 18, 54, 55, 56) mutuellement adjacentes se touchent et dans lequel les sections de bande métallique (12, 14, 15, 17, 18, 54, 55, 56) s'étendent parallèlement les unes aux autres, **caractérisé en ce que** des broches d'insertion sont respectivement formées sur les sections métalliques (12, 14, 15, 17, 18, 54, 55, 56),
dans lequel les sections de bande métallique (12, 14, 15, 17, 18, 54, 55, 56) sont reliées les unes aux autres de manière à ce que des broches d'insertion (3, 4, 8, 9, 32) de sections de bande métallique (12, 14, 15, 17, 18, 54, 55, 56) mutuellement adjacentes soient disposées de manière décalée les unes par rapport aux autres le long de l'étendue longitudinale (44) des sections de bande métallique (12, 14, 15, 17, 18, 54, 55, 56).

2. Contact d'insertion électrique (1, 21, 33) selon la revendication 1,
**caractérisé en ce que** dans lequel le contact d'insertion (1, 21, 33) est formé d'une bande métallique pliée (27), dans lequel un trajet de pliage continu (57) est formé par la bande métallique pliée (27) qui forme un tracé sinueux, et la bande métallique (27) du contact d'insertion (1, 21, 33) est pliée dans des directions mutuellement opposées afin que le contact d'insertion (1, 21, 33) comporte, le long d'un trajet de pliage (57), des sections de bande métallique (54, 55, 56) et des sections de retournement (35, 36) consécutives, dans lequel des sections de bande métallique (54, 55, 56) mutuellement adjacentes sont respectivement reliées les unes aux autres au moyen d'une section de retournement (35, 36), dans lequel des broches d'insertion (3, 4, 8, 9, 32) s'écartant transversalement à la l'étendue longitudinale (44) de la bande métallique (27) sont respectivement formées sur les sections de bande métallique (54, 55, 56) .

3. Contact d'insertion électrique (1, 21, 33) selon la revendication 2,
**caractérisé en ce que** les sections de retournement (35, 36) sont formées de manière à présenter une forme de U.

4. Contact d'insertion électrique (1, 21, 33) selon l'une des revendications précédentes,
**caractérisé en ce qu'**au moins une partie des sections de bande métallique (12, 14, 15, 17, 18, 54, 55, 56) sont reliées entre elles par complémentarité de matériau et sont notamment soudées ou brasées.

5. Contact d'insertion électrique (1, 21, 33) selon l'une des revendications précédentes,
**caractérisé en ce qu'**au moins une partie des broches d'insertion (3, 4, 8, 9, 32) présente un évidement ou une perforation (41), dans lequel la broche d'insertion (3, 4, 8, 9, 32) est réalisée de manière élastique dans la région de la perforation (41).

6. Contact d'insertion électrique (1, 21, 33) selon l'une des revendications précédentes,
**caractérisé en ce que** le contact d'insertion électrique (1, 21, 33) comporte une borne électrique (13, 30), notamment une borne à vis ou à fiche.

7. Contact d'insertion électrique (1, 21, 33) selon l'une des revendications précédentes 2 à 7,
**caractérisé en ce que** la bande métallique (27) comporte, dans son étendue plane, sur un côté opposé aux broches d'insertion (3, 4, 8, 9, 32), des bornes uniformément espacées les unes des autres et s'écartant de la bande métallique (27), qui sont respectivement formées par une languette de tôle (13, 29, 30, 31), dans lequel les languettes de tôle sont repliées les unes sur les autres.

8. Contact d'enfoncement électrique (1, 21, 33) selon l'une des revendications 6 ou 7 précédentes, **caractérisé en ce que** la borne (13, 29, 30, 31) est formée par une terminaison à vis ou une borne enfichable, dans lequel la languette de tôle (13, 29, 30, 32) est emboutie pour produire une borne à vis ou une terminaison enfichable.

9. Système de contact comportant au moins un contact d'insertion (1, 21, 33) selon l'une des revendications précédentes et un support de circuit, dans lequel le support de circuit (58) comporte au moins une couche électriquement conductrice (59) et au moins une couche électriquement isolante (60) et comporte un évidement ou une ouverture (61) pour chaque broche d'insertion (3, 4, 8, 9, 32) du contact d'insertion (1, 21, 33), dans lequel la broche d'insertion (3, 4, 8, 9, 32) est conçue de manière à être maintenue dans le support de circuit (58) par complémentarité de force ou, en outre, par complémentarité de matériau lors de son insertion dans l'évidement ou dans l'ouverture (61).

10. Procédé de fabrication d'un contact d'insertion (1, 21, 33), dans lequel des sections de bande métallique (54, 55, 56) successives d'une bande métallique (27) sont repliées les unes sur les autres le long d'une étendue longitudinale (44),
**caractérisé en ce que** des broches d'insertion (3, 4, 8, 9, 32) s'écartant transversalement à l'étendue longitudinale (44) de la bande métallique (27) sont respectivement formées sur les sections de bande métallique (54, 55, 56), dans lequel les broches d'insertion (3, 4, 8, 9, 32) de sections de bande métallique (12, 14, 15, 17, 18, 54, 55, 56) mutuellement adjacentes sont disposées de manière décalée les unes par rapport aux autres le long de l'étendue longitudinale (44) des sections de bande métallique (12, 14, 15, 17, 18, 54, 55, 56).
